(19)

Europäisches
Patentamt
European
Patent Office
Office européen
des brevets

(11) **EP 4 593 570 A1**

(12) **EUROPEAN PATENT APPLICATION**

(43) Date of publication:
**30.07.2025 Bulletin 2025/31**

(21) Application number: **25153134.9**

(22) Date of filing: **21.01.2025**

(51) International Patent Classification (IPC):
**H10K 59/122** (2023.01)   **H10K 59/80** (2023.01)
**H10K 50/15** (2023.01)   **H10K 50/18** (2023.01)
**H10K 50/852** (2023.01)   **H10K 102/00** (2023.01)
**H10K 50/19** (2023.01)   **H10K 50/85** (2023.01)

(52) Cooperative Patent Classification (CPC):
**H10K 59/122; H10K 50/181; H10K 50/19;**
**H10K 50/852; H10K 59/8052; H10K 59/873;**
**H10K 59/876;** H10K 59/35; H10K 2102/351

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **25.01.2024   CN 202410110015**

(71) Applicants:
• **Hefei Visionox Technology Co., Ltd.**
**Hefei, Anhui 230000 (CN)**
• **Visionox Technology Inc.**
**Suzhou, Jiangsu 215300 (CN)**

(72) Inventors:
• **LOU, Zhenhua**
**Hefei, Anhui, 230000 (CN)**

• **LI, Zhenzhen**
**Hefei, Anhui, 230000 (CN)**
• **LIU, Shaohui**
**Hefei, Anhui, 230000 (CN)**
• **DAI, Kang**
**Hefei, Anhui, 230000 (CN)**
• **WANG, Yan**
**Hefei, Anhui, 230000 (CN)**
• **LIU, Xiaojing**
**Hefei, Anhui, 230000 (CN)**
• **YU, Zhonglong**
**Hefei, Anhui, 230000 (CN)**
• **LIU, Mingxing**
**Hefei, Anhui, 230000 (CN)**

(74) Representative: **Kraus & Lederer PartGmbB**
**Thomas-Wimmer-Ring 15**
**80539 München (DE)**

(54) **DISPLAY PANEL AND DISPLAY DEVICE**

(57)   Embodiments of the present application provides a display panel and a display device, which relates to the field of display technology. The display panel includes an array base plate, a plurality of light-emitting devices, a functional layer and an encapsulation layer. The light-emitting devices, the functional layer and the encapsulation layer form microcavities, and the microcavities corresponding to the respective light-emitting devices of different colors have different lengths. Compared with a solution in the related art in which the light-emitting devices of different colors employ a same device structure, light-emitting performances of the light-emitting devices of different colors can be improved.

Fig. 1

EP 4 593 570 A1

## Description

## TECHNICAL FIELD

The present application relates to the field of display technology, and particularly to a display panel and a display device.

## BACKGROUND

An Organic Light Emitting Device (OLED) is considered as a next generation of a flat panel display technology after a Liquid Crystal device, and it has many unique advantages such as self-luminescence, all-solid state, light weight, flexibility, and the like. For an OLED display panel, a display image is formed by controlling light-emitting devices of different colors to emit light. Due to different light-emitting performances of the light-emitting devices of different colors, how to enable each of the light-emitting devices of different colors to meet a requirement for a better light-emitting performance is a technical problem required to be solved urgently by those skilled in the art.

## SUMMARY

In a first aspect of the present application, there is provided a display panel, including: an array base plate; an isolation structure disposed on the array base plate; a plurality of isolation openings surrounded by the isolation structure; a plurality of light-emitting devices disposed on the array base plate and within the isolation openings; a functional layer disposed on a side of the light-emitting devices away from the array base plate; and an encapsulation layer covering at least the functional layer, wherein the light-emitting devices, the functional layer and the encapsulation layer are configured to form microcavities, and the microcavities corresponding to the respective light-emitting devices of different colors have different lengths.

In a second aspect of the present application, there is further provided a display panel, including: an array base plate; a plurality of light-emitting devices disposed on a side of the array base plate, and the light-emitting device comprises at least two light-emitting layers that are stacked along a direction perpendicular to the array base plate; a functional layer disposed on a side of the light-emitting devices away from the array base plate; and an encapsulation layer covering at least the functional layer, wherein the light-emitting devices, the functional layer and the encapsulation layer are configured to form microcavities, and the microcavities corresponding to the respective light-emitting devices of different colors have different lengths.

In a third aspect of the present application, there is further provided a display device, including the display panel according to any one of the possible implementations in the first aspect or the second aspect.

Embodiments of the present application provides a display panel and a display device. The display panel includes an array base plate, an isolation structure, a plurality of light-emitting devices, a functional layer and an encapsulation layer. The light-emitting devices, the functional layer and the encapsulation layer are configured to form microcavities and the isolation structure isolates the different light-emitting devices, so structures of the microcavities corresponding to the respective light-emitting devices of different colors can be designed differently. In this way, light-emitting performances of the light-emitting devices of different colors can be improved.

## BRIEF DESCRIPTION OF THE DRAWINGS

The drawings required to describe embodiments of the present application are introduced briefly below to illustrate technical solutions of the embodiments of the present application more clearly. It should be understood that the drawings described below only show some embodiments of the present application, and thus should not be regarded as a limitation of the scope. For those skilled in the art, other related drawings may be obtained from these drawings without any inventive efforts.

Fig. 1 illustrates a first one of schematic cross-sectional structural diagrams of a pixel panel according to an embodiment of the present application;
Fig. 2 illustrates a schematic diagram of a positional relationship between the light-emitting devices and the isolation structure shown in Fig. 1;
Fig. 3 illustrates a second one of schematic cross-sectional structural diagrams of a pixel panel according to an embodiment of the present application;
Fig. 4 illustrates a third one of schematic cross-sectional structural diagrams of a pixel panel according to an embodiment of the present application;
Fig. 5 illustrates a fourth one of schematic cross-sectional structural diagrams of a pixel panel according to an embodiment of the present application;
Fig. 6 illustrates a fifth one of schematic cross-sectional structural diagrams of a pixel panel according to an embodiment of the present application;
Fig. 7 illustrates a sixth one of schematic cross-sectional structural diagrams of a pixel panel according to an embodiment of the present application;
Fig. 8 illustrates a first one of comparison tables of test data of the present solution with respect to a related solution;
Fig. 9 illustrates a first one of schematic structural diagrams of a film layer of a light-emitting device according to an embodiment of the present application;
Fig. 10 illustrates a schematic structural diagram of a film layer of a blue light-emitting device according to an embodiment of the present application;

Fig. 11 illustrates a test graph showing improvement of a light-emitting efficiency of a blue light-emitting device by adjusting a thickness of HTL1 or a thickness of HTL2;

Fig. 12 illustrates a schematic structural diagram of a film layer of a red light-emitting device according to an embodiment of the present application;

Fig. 13 illustrates a test graph showing improvement of an efficiency of light-emitting of a red light-emitting device by adjusting a thickness of EBL1 or a thickness of EBL2;

Fig. 14 illustrates a schematic structural diagram of a film layer of a green light-emitting device according to an embodiment of the present application;

Fig. 15 illustrates a test graph showing improvement of an efficiency of light-emitting of a green light-emitting device by adjusting a thickness of EBL1 or a thickness of EBL2;

Fig. 16 illustrates a second one of comparison tables of test data of the present solution with respect to a related solution;

Fig. 17 illustrates a seventh one of schematic cross-sectional structural diagrams of a pixel panel according to an embodiment of the present application;

Fig. 18 illustrates an eighth one of schematic cross-sectional structural diagrams of a pixel panel according to an embodiment of the present application;

Reference numerals: 1-display panel; 11-array base plate; 12-isolation structure; 121-isolation opening; 122-isolation base; 123-isolation part; 124-barrier part; 13-light-emitting device; 131-first electrode; 132-light-emitting device layer; 133-second electrode; 14-functional layer; 15-encapsulation layer; 151-first encapsulation layer; 152-second encapsulation layer; 153-third encapsulation layer; 17-pixel definition layer; 171-pixel opening.

## DETAILED DESCRIPTION

In order to make objects, technical solutions and advantages of the embodiments of the present application clearer, the technical solutions in the embodiments of the present application will be described clearly and completely in conjunction with the accompanying drawings for the embodiments of the present application. Obviously, the described embodiments are merely a part of and not all of the embodiments of the present application. The components in the embodiments of the present application generally described and shown in the accompanying drawings herein can be arranged and designed in various different configurations.

In the description of the present application, it should be noted that orientational or positional relationships indicated by the terms "upper", "lower", and the like are orientational or positional relationships as shown in the accompanying drawings or orientational or positional relationships with which the product of the present application is placed commonly when in use, which are merely to facilitate and simplify the description of the present application, rather than to indicate or imply that the referenced components or elements must have such a particular orientation, or must be constructed and operated in such a particular orientation and thus should not be considered as limitations to the present application.

In some display panels, in order to reduce a difficulty of a vapor deposition process for a light-emitting material, an isolation structure is provided on a pixel definition layer between pixel openings. In vapor deposition of a whole layer of a light-emitting device layer and a whole layer of a cathode layer, the light-emitting device layer and the cathode layer between adjacent pixel openings can be separated at the location of the isolation structure. By multiple vapor deposition processes and multiple etching processes, light-emitting device film layers are formed in the respective pixel openings corresponding to light-emitting devices of different colors.

Reference can be made to patent applications No. PCT/CN2023/134518, CN 202310759370.2, CN 202310740412.8, CN 202310707209.0, and CN 202311346196.5 for related contents of the isolation structure.

In the related art, the light-emitting devices of different colors generally have the same device structure, which means the light-emitting devices of different colors have the same thickness of film layer and have the same device dimension. Since the light-emitting devices of different colors have different light-emitting materials and light-emitting efficiencies, it is very difficult to enable each of the light-emitting devices of different colors to achieve their optimal light-emitting performances by the same device structure.

In order to solve the above problem, the inventors have inventively designed the following technical solutions, and specific implementations of the present application will be described in detail below in conjunction with the accompanying drawings. It should be noted that the above-discussed defects existing in the solution in the related art are founded by the inventors after practices and careful studies. Therefore, both the process of finding the technical problem and the solutions proposed below in the embodiments for the problem shall be contributions made by the inventors to the present application in the course of invention and should not be understood as technical contents commonly known to those skilled in the art.

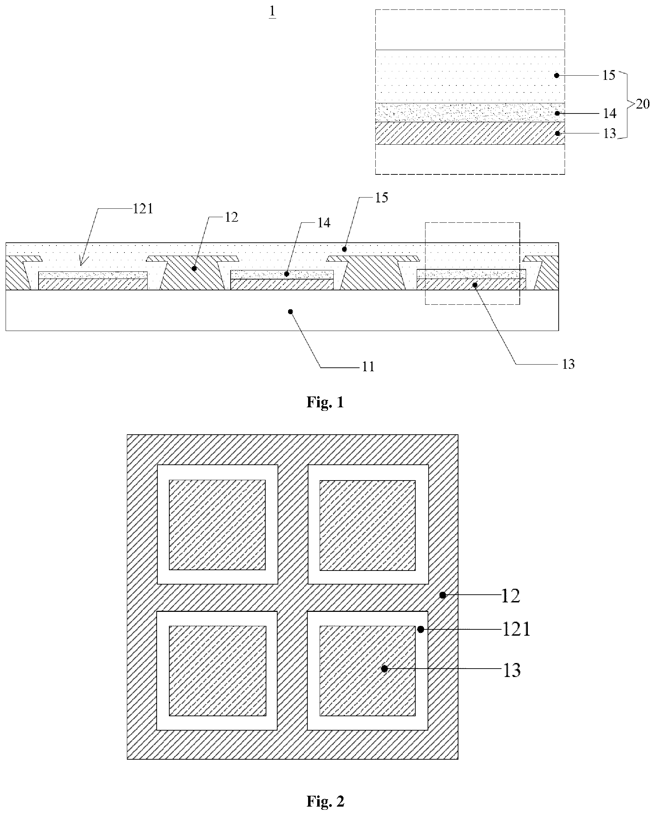

Referring to Figs. 1 and 2, Fig. 1 illustrates a schematic structural diagram of a display panel according to an embodiment of the present application, and Fig. 2 illustrates a schematic diagram of a positional relationship between light-emitting devices and an isolation structure shown in Fig. 1. In this embodiment, the display panel 1 includes an array base plate 11, an isolation structure 12, a plurality of light-emitting devices 13, a functional layer 14, and an encapsulation layer 15. The isolation structure 12 is disposed on a side of the array base plate 11, and a plurality of isolation openings 121 are formed on the array base plate 11 and surrounded by the isolation structure 12. The light-emitting devices 13 are disposed within the isolation openings 121. That is, an orthographic projection of the light-emitting device 13 on the array base plate 11 is located within an orthographic projection of the isolation opening 121 on the array base plate 11, and one light-emitting device 13 may be disposed within each of the isolation openings 121.

The functional layer 14 is disposed on a side of the light-emitting devices 13 away from the array base plate 11 for reducing loss of light reflected during light emission, and the functional layer 14 may be a transparent layer with a higher refractive index. The encapsulation layer 15 covers at least the functional layer 14. Exemplarily, the encapsulation layer 15 may further cover the isolation structure 12. The encapsulation layer 15 has a flat surface at its side away from the array base plate 11, to facilitate forming of a subsequent film layer on the side of the encapsulation layer 15 away from the array base plate 11. In the embodiment of the present application, the light-emitting devices 13, the functional layer 14 and the encapsulation layer 15 are configured to form microcavities 20. In a direction perpendicular to the array base plate 11, each of the microcavities 20 has a length, which is a sum of thicknesses of the three layers of the light-emitting device 13, the functional layer 14 and the encapsulation layer 15.

In this embodiment, the microcavities 20 corresponding to the respective light-emitting devices of different colors have different lengths.

In the above structure, the respective light-emitting devices 13, the functional layer 14 and the encapsulation layer 15 are configured to form the microcavities 20, and the isolation structure 12 isolates different light-emitting devices 13, so structures of the microcavities 20 corresponding to the respective light-emitting devices 13 of different colors can be designed differently. Particularly, the microcavities 20 corresponding to the respective light-emitting devices 13 of different colors have different lengths. Compared with a solution in the related art in which the light-emitting devices 13 of different colors employ the same device structure, light-emitting performances of the light-emitting devices 13 of different colors can be improved.

In the direction perpendicular to the array base plate 11, the functional layer 14 has different thicknesses at different parts corresponding to the respective light-emitting devices of different colors. Herein, the functional layer 14 may include a single film layer, or may include a plurality of film layers (e.g. two film layers), each of which has a refractive index selected according to actual requirements. In this embodiment, the lengths of the microcavities 20 corresponding to the light-emitting devices 13 (i.e. sub-pixel devices) of different colors may be adjusted by adjusting the thicknesses of the functional layer 14. Compared with the related art in which the light-emitting devices 13 of different colors have the same device structure, light-emitting performances of the light-emitting devices 13 of different colors can be improved.

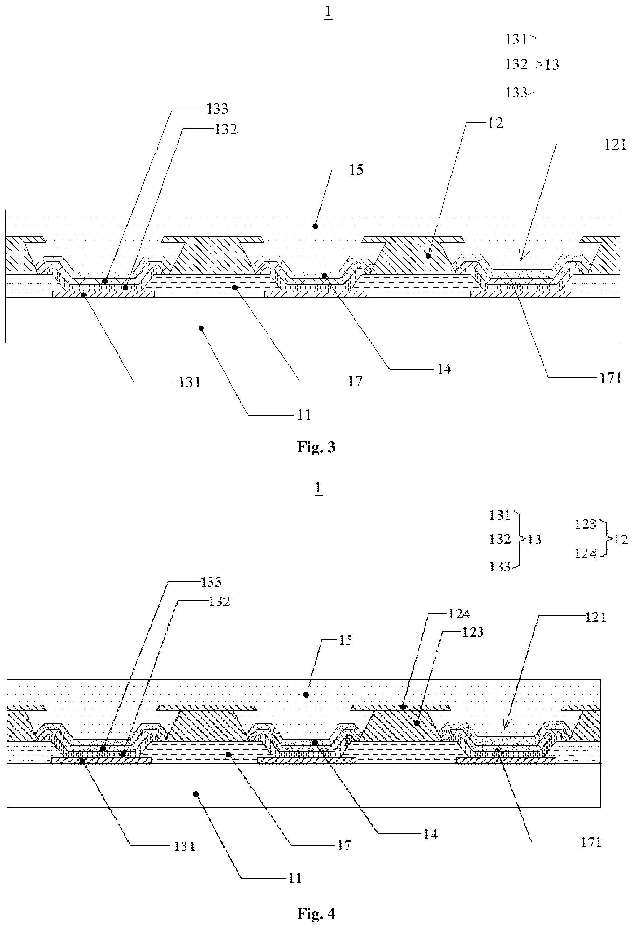

Referring to Fig. 3, each of the light-emitting devices 13 includes a first electrode 131, a light-emitting device layer 132, and a second electrode 133 that are stacked in order in a direction away from the array base plate 11. The display panel 10 may further include a pixel definition layer 17 disposed on a side of the array base plate 11, and the isolation structure 12 is disposed on a side of the pixel definition layer 17 away from the array base plate 11. The pixel definition layer 17 includes a plurality of pixel openings 171 which are connected with the isolation opening 121. Exemplarily, an orthographic projection of the pixel opening 171 on the array base plate 11 covers an orthographic projection of the light-emitting device 13 on the array base plate 11, and an orthographic projection of the isolation opening 171 on the array base plate 11 covers the orthographic projection of the pixel opening 171 on the array base plate 11.

The first electrodes 131 are arranged at intervals on a side of the array base plate 11. Exemplarily, the first electrode 131 is located at least at a position of the array base plate 11 corresponding to the isolation opening 121, and is exposed from the pixel opening 171. The light-emitting device layer 132 extends from the pixel opening 171 to the side of the pixel definition layer 17 away from the array base plate 11, and the second electrode 133 extends from the pixel opening 171 to an edge of the isolation opening 121 and is connected with a part of the isolation structure 12 surrounding the isolation opening 121. In this embodiment, the first electrode 131 may be an anode of the light-emitting device 13, and the second electrode 133 may be a cathode of the light-emitting device 13. Further, the length of the microcavity 20 is a distance between a side of the first electrode 131 away from the array base plate 11 and the side of the encapsulation layer 15 away from the array base plate 11.

Referring to Fig. 4, the isolation structure 12 includes an isolation part 123 and a barrier part 124 that are stacked, wherein the barrier part 124 is disposed on a side of the isolation part 123 away from the array base plate 11, an orthographic projection of the isolation part 123 on the array base plate 11 is located within an orthographic projection of the barrier part 124 on the array base plate 11, and the barrier part 124 protrudes from the isolation part 123 in a direction facing the isolation opening 121. The second electrode 133 extends from the pixel opening 171 to the edge of the isolation opening 121 and overlaps with the isolation part 123.

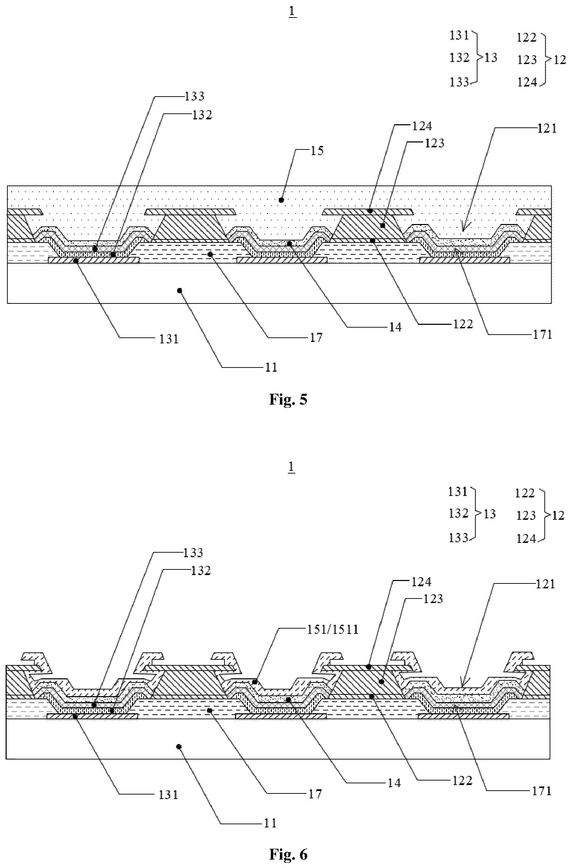

Referring to Fig. 5, in this embodiment, the isolation structure 12 may further include an isolation base 122 such that the isolation base 122, the isolation part 123, and the barrier part 124 are stacked in order, an orthographic projection of the isolation part 123 on the array base plate 11 is located within an orthographic projection of the isolation base 122 on the array base plate 11, and the orthographic projection of the isolation base 122 on the array base plate 11 is located within an orthographic projection of the barrier part 124. That is, both the isolation base 122 and the barrier part 124 protrude from the isolation part 123 in the direction facing the isolation opening 121. Exemplarily, the second electrode 133 extends from the pixel opening 171 to the edge of the isolation opening 121 and overlaps with the isolation base 122.

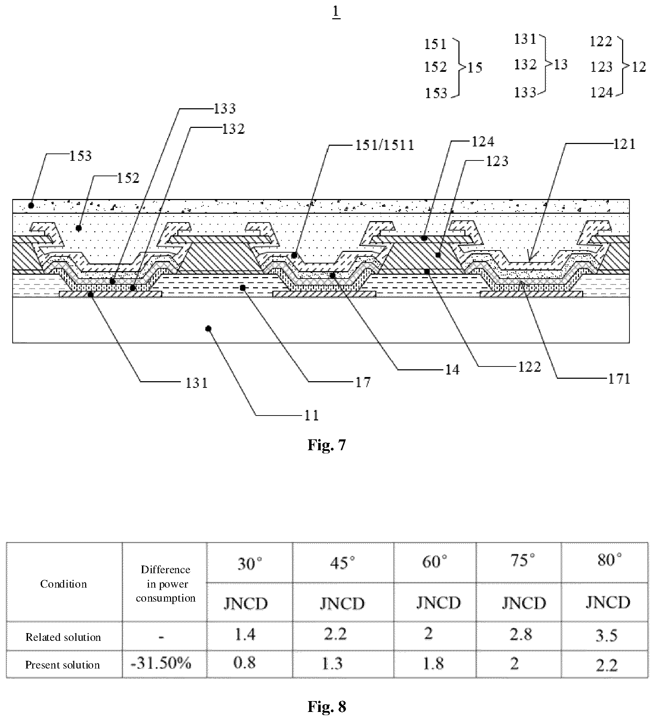

Referring to Fig. 6, the encapsulation layer 15 may include a first encapsulation layer 151, and the first encapsulation layer 151 includes a plurality of encapsulation units 1511, adjacent ones of which are separated by the isolation structure 12. The encapsulation unit 1511 may include an inorganic material, and the encapsulation unit 1511 may be manufactured by chemical vapor deposition. Each of the encapsulation units 1511 is configured to encapsulate one of the light-emitting devices 13 in a corresponding one of the isolation openings 121 independently. Referring to Fig. 7, the encapsulation layer 15 may further include a second encapsulation layer 152 and a third encapsulation layer 153, the second encapsulation layer 152 covers the isolation structure 12 and the light-emitting devices 13, and has a flat surface at its side away from the array base plate 11. The third encapsulation layer 153 is disposed on a side of the second encapsulation layer 152 away from the array base plate 11. Herein, the second encapsulation layer 152 may be manufactured by ink-jet printing, and the third encapsulation layer 153 may be manufactured by chemical vapor deposition. The first encapsulation layer 151 and the third encapsulation layer 153 are inorganic encapsulation layers, the second encapsulation layer 152 is an organic encapsulation layer, and the first encapsulation layer 151, the second encapsulation layer 152 and the third encapsulation layer 153 form a thin film encapsulation structure of the display panel 10.

In order to improve a light output efficiency to reduce power consumption of the light-emitting device 13, the light output efficiency may be improved by taking advantages of microcavity resonance (reflected light is interfered constructively in the microcavity), in which the first electrode serves as a full-reflection electrode of the microcavity 20, and the second electrode serves as a semi-reflection electrode of the microcavity 20. In this embodiment, the microcavity resonance can be achieved by adjusting a length of each of the microcavities 20 corresponding to the respective light-emitting devices 13, wherein each of the microcavities 20 corresponding to the respective light-emitting device 13 has a length positively correlated with a wavelength of light produced by a corresponding one of the light-emitting devices 13, that is, the greater the wavelength of the light produced by the light-emitting device 13, the greater the length of the microcavity 20 corresponding to the light-emitting device 13.

Exemplarily, the length L of the microcavity 20 may be calculated by the following formula:

$$2L = 2\sum_i n_i \times d_i + \psi_1 + \psi_2 = m \times \lambda$$

Herein, $n_i$ is an refractive index of an $i^{th}$ film layer in the microcavity, $d_i$ is a thickness of the $i^{th}$ film layer in the microcavity, $\psi_1$ and $\psi_2$ are reflective phase shifts of the full-reflection electrode and the semi-reflection electrode in the microcavity respectively, $m$ is an order of the microcavity, and $\lambda$ is a resonant wavelength of the microcavity, where $m$ is a positive integer.

In this embodiment, $m$ may have a value of 2, and $L = \lambda$, i.e., the length L of the microcavity 20 is equal to the resonant wavelength of the second-order microcavity. When the resonant wavelength of the second-order microcavity is equal to the wavelength of the light produced by the light-emitting device 13, the reflected light can be constructively interfered completely in the microcavity 20, so as to improve the light output efficiency to reduce the power consumption of the device.

The light-emitting devices 13 include a first light-emitting device, a second light-emitting device, and a third light-emitting device. The first light-emitting device, the second light-emitting device and the third light-emitting device are configured to produce light of different colors, and wavelengths of the light produced by the first light-emitting device, the second light-emitting device, and the third light-emitting device are decreased in order. Exemplarily, the first light-emitting device, the second light-emitting device, and the third light-emitting device may respectively correspond to a red light-emitting device R, a green light-emitting device G, and a blue light-emitting device B,. The red light-emitting device R, the green light-emitting device G, and the blue light-emitting device B form a light-emitting pixel. The color and brightness of the light-emitting pixel can be adjusted by changing brightness of light emitted by the red light-emitting device R, the green light-emitting device G, and the blue light-emitting device B. The description is provided by taking that the first light-emitting device, the second light-emitting device, and the third light-emitting device corresponding to the red light-emitting device R, the green light-emitting device G, and the blue light-emitting device B, respectively as an example.

An enhancement effect of the microcavity 20 on light emitted by the light-emitting device 13 may be measured using a full width at half maximum FWHM, and the full width at half maximum FWHM may be calculated as follows:

$$FWHM = \frac{\lambda^2}{2L} \times \frac{1 - \sqrt{R_1 R_2}}{\pi \sqrt[4]{R_1 R_2}}$$

Herein, $R_1$ and $R_2$ are a reflectivity of the full-reflection electrode and a reflectivity of the semi-reflection electrode, respectively. The smaller the full width at half maximum FWHM, the greater an extent of enhancement of the microcavity 20 on the light emitted by the light-emitting device 13 and the narrower a range of wavelength of the emitted light.

Since the blue light-emitting device B (i.e. the third light-emitting device) has a lower light-emitting efficiency, a thickness of the second electrode 133 of the blue light-emitting device B may be increased, to reduce the full width at half maximum FWHM of the microcavity corresponding to the blue light-emitting device B and to increase the light-emitting efficiency of the blue light-emitting device. However, green light produced by the green light-emitting device G (the second light-emitting device) occupies the largest proportion of white light to be synthesized, so in order to avoid resulting attenuation of brightness of the white light, a range of wavelength of the emitted green light is required to be as wide as possible, and the full width at half maximum FWHM of the microcavity corresponding to the green light-emitting device G is required to be as large as possible, that is, the second electrode 133 of the green light-emitting device G should not be too thicker. For this reason, in the embodiment of the present application, the thickness of the second electrode 133 of the blue light-emitting device B, the thickness of the second electrode 133 of the red light-emitting device R (i.e. the first light-emitting device) and the thickness of the second electrode 133 of the green light-emitting device G are decreased in order.

Further, in order to enable the lengths of the microcavities 20 corresponding to the light-emitting devices 13 of various colors to be matched with the wavelengths of the light produced by the light-emitting devices 13 respectively, the thicknesses of the functional layer 14 on the respective light-emitting devices 13 of various colors may be adjusted. Particularly, the light produced by the red light-emitting device R has a longest wavelength, so a part of the functional layer 14 on the red light-emitting device R has the greatest thickness; the light produced by the green light-emitting device G has a less long wavelength, so a part of the functional layer 14 on the green light-emitting device G has a less great thickness; and the light produced by the blue light-emitting device B has a shortest wavelength, so a part of the functional layer 14 on the blue light-emitting device B has the smallest thickness. That is, in the embodiment of the present application, the thickness of the part of the functional layer 14 on the blue light-emitting device B, the thickness of the part of the functional layer 14 on the green light-emitting device G, and the thickness of the part of the functional layer 14 on the red light-emitting device R are increased in order.

Referring to Fig. 8, Fig. 8 illustrates comparison tables of the present solution with respect to a related solution in which the light-emitting devices of different colors have the same device structure. Compared with the related solution, the power consumption of the present solution is reduced by 31.5%. Moreover, a Just Noticeable Color Difference (JNCD) under each of different viewing angles is also lower than that of the related solution. Exemplarily, when the viewing angle is 30°, the Just Noticeable Color Difference of the present solution is 0.8, which is 0.6 less than the related solution. When the viewing angle is 45°, the Just Noticeable Color Difference of the present solution is 1.3, which is 0.9 less than the related solution. When the viewing angle is 60°, the Just Noticeable Color Difference of the present solution is 1.8, which is 0.2 less than the related solution. When the viewing angle is 75°, the Just Noticeable Color Difference of the present solution is 2, which is 0.8 less than the related solution. When the viewing angle is 80°, the Just Noticeable Color Difference of the present solution is 2.2, which is 1.3 less than the related solution. That is, it can be seen from the data that the solution according to the present application can reduce the power consumption of the display panel and reduce the Just Noticeable Color Difference under various viewing angles.

In the embodiment of the present application, the light-emitting device 13 may be a stacked light-emitting device. That is, each of the light-emitting devices 13 may include at least two light-emitting layers that are stacked along the direction perpendicular to the array base plate 11. Further, orthographic projections of the respective light-emitting layers on the array base plate may completely overlap with each other.

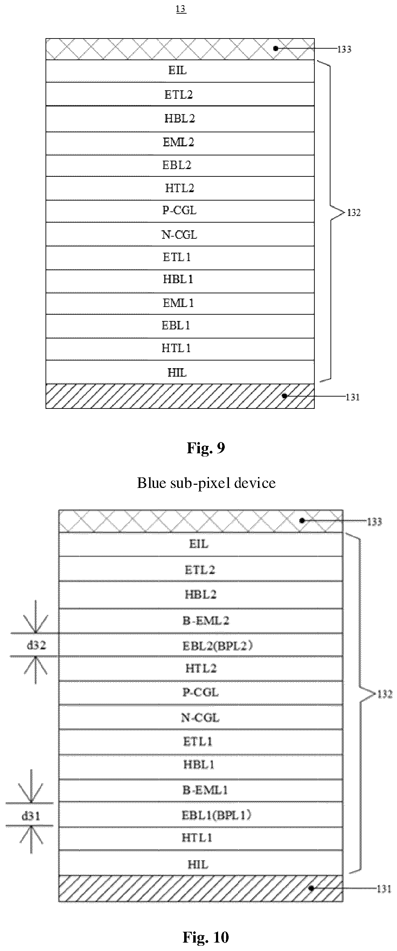

Exemplarily, the description is provided by taking that the light-emitting device 13 includes two light-emitting layers as an example. It should be understood that the same applies to the case of three or more light-emitting layers. Referring to Fig. 9, in the direction away from the array base plate 11, the light-emitting device layer 132 includes a hole injection layer HIL, a first hole transport layer HTL1, a first electron blocking layer EBL1, a first light-emitting layer EML1, a first hole blocking layer HBL1, a first electron transport layer ETL1, an N-type charge generation layer N-CGL, a P-type charge generation layer P-CGL, a second hole transport layer HTL2, a second electron blocking layer EBL2, a second light-emitting layer EML2, a second hole blocking layer HBL2, a second electron transport layer ETL2, and an electron injection layer EIL that are stacked in order.

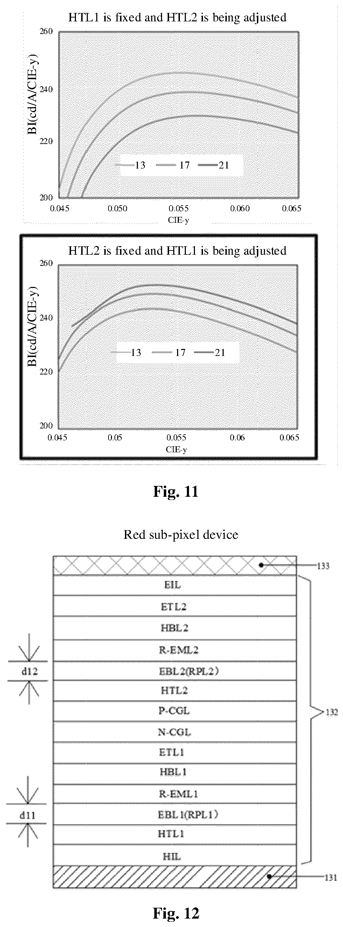

In this embodiment, in order to improve light-emitting efficiency of the stacked light-emitting devices of different colors, thicknesses of the various film layers in the light-emitting device layer 132 may be adjusted. Exemplarily, thicknesses of the first hole transport layer HTL1 and the second hole transport layer HTL2 may be adjusted to improve the light-emitting efficiency of the blue light-emitting device B (i.e. the third light-emitting device). Referring to Figs. 10 and 11, from a comparison of a case where the thickness of the HTL1 is fixed while the thickness of the HTL2 is being adjusted with another case where the thickness of the HTL2 is fixed while the thickness of the HTL1 is being adjusted, it can be seen that the case where the thickness of the HTL2 is fixed while the thickness of the HTL1 is being adjusted results a more obvious effect on improvement of the light-emitting efficiency of the blue light-emitting device B, and results a smaller difference between chroma-light intensity curves of the HTL1 under different thicknesses. In this way, a greater change in the light-emitting efficiency due to a varying thickness of the HTL1 caused by an error in its vapor deposition can be avoided. That is, in this embodiment, the light-emitting efficiency of the blue light-emitting device B can be improved by adjusting the thickness of the HTL1.

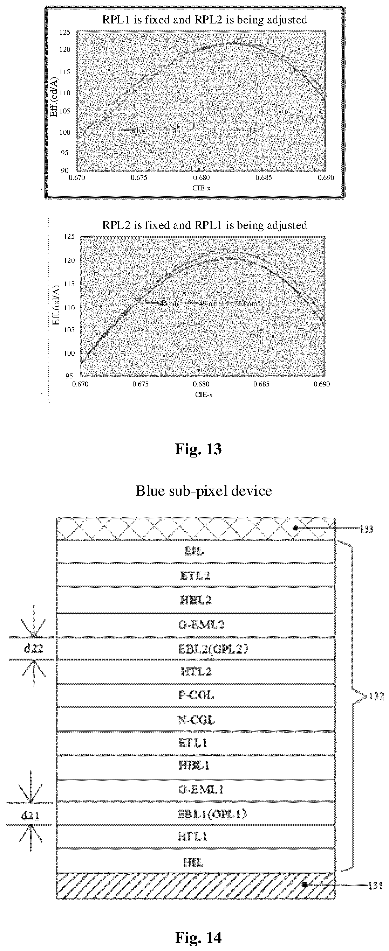

Exemplarily, thickness of the first electron blocking layer EBL1 or the thickness of the second electron blocking layer EBL2 in the red light-emitting device R may be adjusted to improve the light-emitting efficiency of the red light-emitting device R (i.e. the first light-emitting device). Referring to Figs. 12 and 13, it can be seen that the case where the thickness of the EBL1(RPL1) is fixed while the thickness of the EBL2(RPL2) is being adjusted will results a higher light-emitting efficiency of the red light-emitting device R, and results a smaller difference between chroma-light intensity curves of the EBL2(RPL2) under different thicknesses. In this way, a greater change in the light-emitting efficiency due to a varying thickness of the EBL2(RPL2) caused by an error in its vapor deposition can be avoided. That is, in this embodiment, the light-emitting efficiency of the red light-emitting device R can be improved by adjusting the thickness of the EBL2(RPL2).

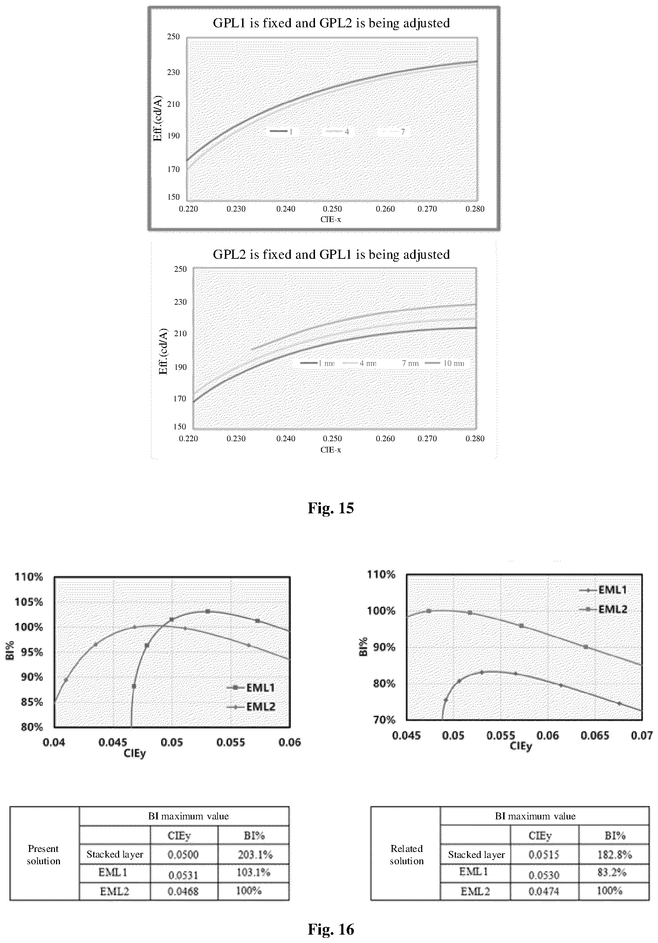

Similarly, thickness of the first electron blocking layer EBL1 or the thickness of the second electron blocking layer EBL2 in the green light-emitting device G may be adjusted to improve the light-emitting efficiency of the green light-emitting device G (i.e. the second light-emitting device). Referring to Figs. 14 and 15, it can be seen that the case where the thickness of the EBL1(GPL1) is fixed while the thickness of the EBL2(GPL2) is being adjusted will results a higher light-emitting efficiency of the green light-emitting device G, and results a smaller difference between chroma-light intensity curves of the EBL2(GPL2) under different thicknesses. In this way, a greater change in the light-emitting efficiency due to a varying thickness of the EBL2(GPL2) caused by an error in its vapor deposition can be avoided. That is, in this embodiment, the light-emitting efficiency of the green light-emitting device G can be improved by adjusting the thickness of the EBL2(GPL2).

In this embodiment, the light-emitting efficiencies of the three kinds of light-emitting devices 13 of different colors can be improved by adjusting the thickness of the HTL1 in the blue light-emitting device B, the thickness of the EBL2 (RPL2) in the red light-emitting device R, and the thickness of the EBL2 (GPL2) in the green light-emitting device G, so as to reduce the power consumption of the light-emitting devices 13.

Further, in this embodiment, still referring to Figs. 10, 12 and 14, a sum of thicknesses of the first electron blocking layer EBL1 and the second electron blocking layer EBL2 in the red light-emitting device R is a first thickness (d11+d12), a sum of thicknesses of the first electron blocking layer EBL1 and the second electron blocking layer EBL2 in the green light-emitting device G is a second thickness (d21+d22), and a sum of thicknesses of the first electron blocking layer EBL1 and the second electron blocking layer EBL2 in the blue light-emitting device B is a third thickness (d31+d32), wherein the first thickness, the second thickness and the third thickness are not equal to each other. Exemplarily, the first thickness, the second thickness and the third thickness are decreased in order.

In the embodiment of the present application, in the direction perpendicular to the array base plate, the thickness d12 of the second electron blocking layer in the red light-emitting device R, the thickness d22 of the second electron blocking layer in the green light-emitting device G, and the thickness d23 of the second electron blocking layer in the blue light-emitting device B are decreased in order.

In the embodiment of the present application, in order to improve a light output rate of the light-emitting device 13, a distance between the first light-emitting layer EML1 and the first electrode 131 within the light-emitting device 13 is not less than a distance D, which is calculated as the following formula:

$$D=0.33* (\lambda/n) -54$$

wherein $\lambda$ is a resonant wavelength of a microcavity corresponding to the light-emitting device, and n is a refractive index of a medium between the first light-emitting layer and the first electrode.

Referring to Fig. 16, Fig. 16 illustrates schematic comparison tables of a light-emitting efficiency of a stacked light-emitting device according to an embodiment of the present application and a light-emitting efficiency of a stacked light-emitting device in the related art. Under substantially the same chroma CIEy, a maximum value of a light-emitting intensity BI of the first light-emitting layer EML1 in the light-emitting device 13 according to the embodiment of the present application can be greatly improved, such that an overall light-emitting efficiency of the light-emitting device 13 can be improved. Exemplarily, as shown in Fig. 16, in the related art, a maximum value of a light-emitting intensity BI of the first light-emitting layer EML1 is 83.2%, a maximum value of a light-emitting intensity BI of the second light-emitting layer EM2 is 100%, so a maximum value of a total light-emitting intensity BI of the light-emitting device 13 is 183.2%; while in the embodiment of the present application, the maximum value of the light emitting intensity BI of the first light-emitting layer EML1 is 103.1%, a maximum value of a light-emitting intensity BI of the second light-emitting layer EM2 is 100%, so a maximum value of a total light-emitting intensity BI of the light-emitting device 13 is 203.1%. That is, both the light-emitting intensity of the first light-emitting layer EML1 of the light-emitting device 13 and the total light-emitting intensity of the light-emitting device 13 according to the embodiment of the present application are improved compared with the related art.

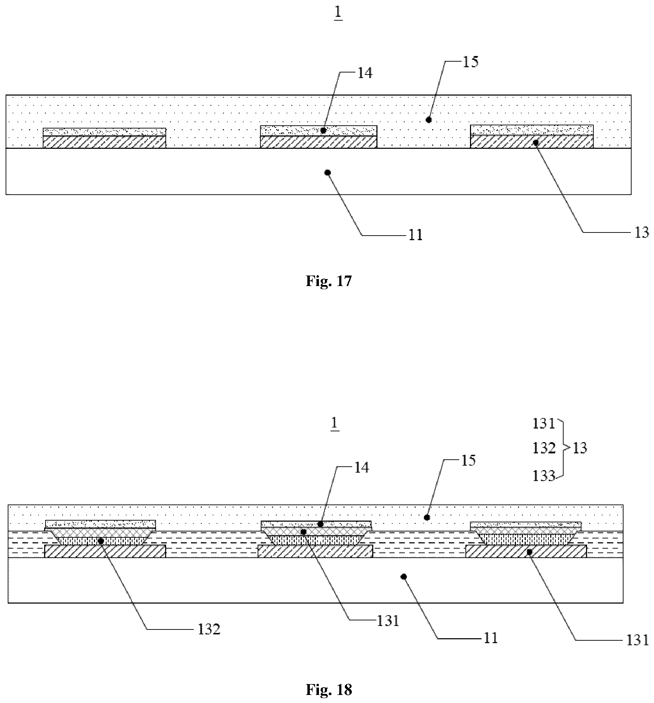

Based on a same inventive concept, the embodiments of the present application further provide a display panel. Referring to Fig. 17, the display panel 1 includes an array base plate 11, a plurality of light-emitting devices 13, a functional layer 14, and an encapsulation layer 15. The light-emitting devices 13 are disposed on a side of the array base plate 11, and the light-emitting device 13 includes at least two light-emitting layers that are stacked along a direction perpendicular to the array base plate 11. In some embodiments, orthographic projections of the at least two light-emitting layers on the array base plate 11 are completely overlapped with each other.

The functional layer 14 is disposed on a side of the light-emitting devices 13 away from the array base plate 11 for reducing loss of light reflected during light emission, and the functional layer 14 may be a transparent layer with a higher refractive index. The encapsulation layer 15 covers at least the functional layer 14, and has a flat surface at its side away from the array base plate 11, to facilitate forming of a subsequent film layer at the side of the encapsulation layer 15 away from the array base plate 11. In the embodiment of the present application, a film layer on a side of the first electrode of the light-emitting device 13 away from the array base plate 11 participates in forming a microcavity 20. That is, microcavities 20 are formed by the respective light-emitting devices 13, the functional layer 14 and the encapsulation layer 15 that are stacked in order along the direction away from the array base plate 11. In a direction perpendicular to the array base plate 11, each of the microcavity 20 has a length, which is a sum of thicknesses of the three layers of the light-emitting device 13, the functional layer 14 and the encapsulation layer 15.

In this embodiment, the microcavities 20 corresponding to the respective light-emitting devices of different colors have different lengths.

In the above structure, the microcavities 20 corresponding to the respective light-emitting devices 13 of different colors have different lengths. Compared with a solution in the related art in which the light-emitting devices 13 of different colors employ a same device structure, light-emitting performances of the light-emitting devices 13 of different colors can be improved.

In the direction perpendicular to the array base plate 11, the functional layer 14 has different thicknesses at positions corresponding to the light-emitting devices of different colors. Herein, the functional layer 14 may include a single film layer, or may include a plurality of film layers (e.g. two film layers), each of which has a refractive index selected according to actual requirements. In this embodiment, the lengths of the microcavities 20 corresponding to the light-emitting devices 13 (i.e. sub-pixel devices) of different colors may be adjusted by adjusting the thicknesses of the functional layer 14. Compared with the related art in which the light-emitting devices 13 of different colors have the same device structure, light-emitting performances of the light-emitting devices 13 of different colors can be improved.

In this embodiment, in order to improve a light output efficiency to reduce power consumption of the light-emitting device 13, the light output efficiency may be improved by taking advantages of microcavity resonance (reflected light is interfered constructively in the microcavity), in which the first electrode serves as a full-reflection electrode of the microcavity 20, and the second electrode serves as a semi-reflection electrode of the microcavity 20. In this embodiment, the microcavity resonance can be achieved by adjusting a length of each of the microcavities 20 corresponding to the respective light-emitting device 13, wherein each of the microcavities 20 corresponding to the respective light-emitting devices 13 has a length positively correlated with a wavelength of light produced by a corresponding one of the light-emitting device 13s, that is, the greater the wavelength of the light produced by the light-emitting device 13, the greater the length of the microcavity 20 corresponding to the light-emitting device 13.

Exemplarily, the length L of the microcavity 20 may be calculated by the following formula:

$$2L = 2\sum_i n_i \times d_i + \psi_1 + \psi_2 = m \times \lambda$$

Herein, $n_i$ is an refractive index of an $i^{th}$ film layer in the microcavity, $d_i$ is a thickness of the $i^{th}$ film layer in the microcavity, $\psi_1$ and $\psi_2$ are reflective phase shifts of the full-reflection electrode and the semi-reflection electrode in the microcavity respectively, $m$ is an order of the microcavity, and $\lambda$ is a resonant wavelength of the microcavity, where $m$ is a positive integer.

In this embodiment, a $m$ may have a value of 2, and $L = \lambda$, i.e., the length L of the microcavity 20 is equal to the resonant wavelength of the second-order microcavity. When the resonant wavelength of the second-order microcavity is equal to the wavelength of the light produced by the light-emitting device 13, the reflected light can be constructively interfered completely in the microcavity 20, so as to improve the light output efficiency to reduce the power consumption of the device.

The light-emitting devices 13 include a first light-emitting device, a second light-emitting device, and a third light-emitting device. The first light-emitting device, the second light-emitting device and the third light-emitting device are configured to produce light of different colors, and wavelengths of the light produced by the first light-emitting device, the second light-emitting device, and the third light-emitting device are decreased in order. Exemplarily, the first light-emitting device, the second light-emitting device, and the third light-emitting device may respectively correspond to a red light-emitting device R, a green light-emitting device G, and a blue light-emitting device B,. The red light-emitting device R, the green light-emitting device G, and the blue light-emitting device B form a light-emitting pixel. The color and brightness of the light-emitting pixel can be adjusted by changing brightness of light emitted by the red light-emitting device R, the green light-emitting device G, and the blue light-emitting device B. The description is provided by taking that the first light-emitting device, the second light-emitting device, and the third light-emitting device corresponding to the red light-emitting device R, the green light-emitting device G, and the blue light-emitting device B, respectively as an example.

Referring to Fig. 18, each of the light-emitting devices 13 includes a first electrode 131, a light-emitting device layer 132, and a second electrode 133 that are stacked in order in a direction away from the array base plate 11. The display panel 10 may further include a pixel definition layer 17 disposed on a side of the array base plate 11,, and the pixel definition layer 17 includes a plurality of pixel openings, within which the light-emitting devices 13 are disposed. In this embodiment, the first electrode 131 may be an anode of the light-emitting device 13, and the second electrode 133 may be a cathode of the light-emitting device 13. The first electrode serves as a full-reflection electrode of the microcavity 20, and the second electrode serves as a semi-reflection electrode of the microcavity 20. Further, the length of the microcavity 20 is a distance between a side of the first electrode 131 away from the array base plate 11 and the side of the encapsulation layer 15 away from the array base plate 11.

In this embodiment, still referring to Fig. 9, in the direction away from the array base plate 11, the light-emitting device layer 132 includes a hole injection layer HIL, a first hole transport layer HTL1, a first electron blocking layer EBL1, a first light-emitting layer EML1, a first hole blocking layer HBL1, a first electron transport layer ETL1, an N-type charge generation layer N-CGL, a P-type charge generation layer P-CGL, a second hole transport layer HTL2, a second electron blocking layer EBL2, a second light-emitting layer EML2, a second hole blocking layer HBL2, a second electron transport layer ETL2, and an electron injection layer EIL that are stacked in order.

In this embodiment, in order to improve light-emitting efficiency of the stacked light-emitting devices of different colors, thicknesses of the various film layers in the light-emitting device layer 132 may be adjusted. Exemplarily, thicknesses of the first hole transport layer HTL1 and the second hole transport layer HTL2 may be adjusted to improve the light-emitting efficiency of the blue light-emitting device B (i.e. the third light-emitting device). Referring to Figs. 10 and 11, from a comparison of a case where the thickness of the HTL1 is fixed while the thickness of the HTL2 is being adjusted with another case where the thickness of the HTL2 is fixed while the thickness of the HTL1 is being adjusted, it can be seen that the case where the thickness of the HTL2 is fixed while the thickness of the HTL1 is being adjusted results a more obvious effect on improvement of the light-emitting efficiency of the blue light-emitting device B, and results a smaller difference between chroma-light intensity curves of the HTL1 under different thicknesses. In this way, a greater change in the light-emitting efficiency due to a varying thickness of the HTL1 caused by an error in its vapor deposition can be avoided. That is, in this embodiment, the light-emitting efficiency of the blue light-emitting device B can be improved by adjusting the thickness of the HTL1.

Exemplarily, thickness of the first electron blocking layer EBL1 or the thickness of the second electron blocking layer EBL2 in the red light-emitting device R may be adjusted to improve the light-emitting efficiency of the red light-emitting device R (i.e. the first light-emitting device). Referring to Figs. 12 and 13, it can be seen that the case where the thickness of the EBL1(RPL1) is fixed while the thickness of the EBL2(RPL2) is being adjusted will results a higher light-emitting efficiency of the red light-emitting device R, and results a smaller difference between chroma-light intensity curves of the EBL2(RPL2) under different thicknesses. In this way, a greater change in the light-emitting efficiency due to a varying thickness of the EBL2(RPL2) caused by an error in its vapor deposition can be avoided. That is, in this embodiment, the light-emitting efficiency of the red light-emitting device R can be improved by adjusting the thickness of the EBL2(RPL2).

Similarly, thickness of the first electron blocking layer EBL1 or the thickness of the second electron blocking layer EBL2 in the green light-emitting device G may be adjusted to improve the light-emitting efficiency of the green light-emitting device G (i.e. the second light-emitting device). Referring to Figs. 14 and 15, it can be seen that the case where the thickness of the EBL1(GPL1) is fixed while the thickness of the EBL2(GPL2) is being adjusted will results a higher light-emitting efficiency of the green light-emitting device G, and results a smaller difference between chroma-light intensity curves of the EBL2(GPL2) under different thicknesses. In this way, a greater change in the light-emitting efficiency due to a varying thickness of the EBL2(GPL2) caused by an error in its vapor deposition can be avoided. That is, in this embodiment, the light-emitting efficiency of the green light-emitting device G can be improved by adjusting the thickness of the EBL2(GPL2).

In this embodiment, the light-emitting efficiencies of the three kinds of light-emitting devices 13 of different colors can be improved by adjusting the thickness of the HTL1 in the blue light-emitting device B, the thickness of the EBL2 (RPL2) in the red light-emitting device R, and the thickness of the EBL2 (GPL2) in the green light-emitting device G, so as to reduce the power consumption of the light-emitting devices 13.

Further, in this embodiment, still referring to Figs. 10, 12 and 14, a sum of thicknesses of the first electron blocking layer EBL1 and the second electron blocking layer EBL2 in the red light-emitting device R is a first thickness (d11+d12), a sum of thicknesses of the first electron blocking layer EBL1 and the second electron blocking layer EBL2 in the green light-emitting device G is a second thickness (d21+d22), and a sum of thicknesses of the first electron blocking layer EBL1 and the second electron blocking layer EBL2 in the blue light-emitting device B is a third thickness (d31+d32), wherein the first thickness, the second thickness, and the third thickness are not equal to each other. Exemplarily, the first thickness, the second thickness, and the third thickness are decreased in order.

In this embodiment, in the direction perpendicular to the array base plate, the thickness d12 of the second electron blocking layer in the red light-emitting device R, the thickness d22 of the second electron blocking layer in the green light-emitting device G, and the thickness d23 of the second electron blocking layer in the blue light-emitting device B are decreased in order.

In this embodiment, in order to improve a light output rate of the light-emitting device 13, a distance between the first light-emitting layer EML1 and the first electrode 131 within the light-emitting device 13 is not less than a distance D, which is calculated as the following formula:

$$D=0.33*（\lambda/n）-54$$

wherein $\lambda$ is a resonant wavelength of a microcavity corresponding to the light-emitting device, and n is a refractive index of a medium between the first light-emitting layer and the first electrode.

In this embodiment, an enhancement effect of the microcavity 20 on light emitted by the light-emitting device 13 may be measured using a full width at half maximum FWHM, and the full width at half maximum FWHM may be calculated as follows:

$$FWHM = \frac{\lambda^2}{2L} \times \frac{1-\sqrt{R_1 R_2}}{\pi \sqrt[4]{R_1 R_2}}$$

Herein, $R_1$ and $R_2$ are a reflectivity of the full-reflection electrode and a reflectivity of the semi-reflection electrode, respectively. The smaller the full width at half maximum FWHM, the greater an extent of enhancement of the microcavity 20 on the light emitted by the light-emitting device 13 and the narrower a range of wavelength of the emitted light.

Since the blue light-emitting device B (i.e. the third light-emitting device) has a lower light-emitting efficiency, a thickness of the second electrode 133 of the blue light-emitting device B may be increased, to reduce the full width at half maximum FWHM of the microcavity corresponding to the blue light-emitting device B and to increase the light-emitting efficiency of the blue light-emitting device. However, green light produced by the green light-emitting device G (the second light-emitting device) occupies the largest proportion of white light to be synthesized, so in order to avoid resulting attenuation of brightness of the white light, a range of wavelength of the emitted green light is required to be as wide as possible, and the full width at half maximum FWHM of the microcavity corresponding to the green light-emitting device G is required to be as large as possible, that is, the second electrode 133 of the green light-emitting device G should not be too thicker. For this reason, in this embodiment, the thickness of the second electrode 133 of the blue light-emitting device B, the thickness of the second electrode 133 of the red light-emitting device R (i.e. the first light-emitting device), and the thickness of the second electrode 133 of the green light-emitting device G are decreased in order.

Further, in order to enable the lengths of the microcavities 20 corresponding to the light-emitting devices 13 of various colors to be matched with the wavelengths of the light produced by the light-emitting devices 13 respectively, the thicknesses of the functional layer 14 on the respective light-emitting devices 13 of various colors may be adjusted. Particularly, the light produced by the red light-emitting device R has a longest wavelength, so a part of the functional layer 14 on the red light-emitting device R has the greatest thickness; the light produced by the green light-emitting device G has a less long wavelength, so a part of the functional layer 14 on the green light-emitting device G has a less great thickness; and the light produced by the blue light-emitting device B has a shortest wavelength, so a part of the functional layer 14 on the blue light-emitting device B has the smallest thickness. That is, in the embodiment of the present application, the thickness of the part of the functional layer 14 on the blue light-emitting device B, the thickness of the part of the functional layer 14 on the green light-emitting device G and the thickness of the part of the functional layer 14 on the red light-emitting device R are increased in order.

Based on the same inventive concept, the embodiments of the present application further provide a display device, including the display panel described in the above embodiments, which can improve the light-emitting performances of the light-emitting devices of different colors, so that under a same display brightness, required power consumption is less, which is beneficial for improving a stand-by time of the display device.

In summary, the embodiments of the present application provides a display panel and a display device. The display panel includes an array base plate, an isolation structure, light-emitting devices, a functional layer, and an encapsulation layer. The light-emitting devices, the functional layer, and the encapsulation layer are configured to form microcavities, and the isolation structure isolates different light-emitting devices, so structures of microcavities corresponding to the respective light-emitting devices of different colors can be designed differently. Compared with a solution in the related art in which the light-emitting devices of different colors employ a same device structure, light-emitting performances of the light-emitting devices of different colors can be improved.

The above descriptions are merely the preferred embodiments of the present invention and are not used for limiting the present application, and various modifications and variations may be made to the present application for those skilled in the art. Any modification, equivalent replacement and improvement made within the gist and principle of the present application shall fall within the protection scope of the present application.

## Claims

1. A display panel, comprising:

    an array base plate (11);
    a plurality of light-emitting devices (13) disposed on a side of the array base plate (11);
    a functional layer (14) disposed on a side of the light-emitting devices (13) away from the array base plate (11); and
    an encapsulation layer (15) covering at least the functional layer (14),
    wherein the light-emitting devices (13), the functional layer (14) and the encapsulation layer (15) are configured to form microcavities (20), and the microcavities (20) corresponding to the respective light-emitting devices (13) of different colors have different lengths.

2. The display panel according to claim 1, further comprising

    an isolation structure (12) disposed on the array base plate (11),
    a plurality of isolation openings (121) surrounded by the isolation structure (12);
    the plurality of light-emitting devices (13) disposed on the array base plate (11) and within the isolation openings (121).

3. The display panel according to claim 1, wherein each of the microcavities (20) corresponding to the respective light-emitting devices (13) has a length positively correlated with a wavelength of light produced by a corresponding one of the light-emitting devices (13).

4. The display panel according to claim 3, wherein the length of each of the microcavities (20) corresponding to the respective light-emitting devices (13) is equal to the wavelength of light produced by the corresponding one of the light-emitting devices (13).

5. The display panel according to any of claim 1 to 4, wherein

    each of the light-emitting devices (13) comprises a first electrode (131), a light-emitting device layer (132) and a second electrode (133) that are stacked in order in a direction away from the array base plate (11);
    the light-emitting devices (13) comprise a first light-emitting device, a second light-emitting device and a third light-emitting device;
    in a direction perpendicular to the array base plate (11), a thickness of the second electrode of the third light-emitting device, a thickness of the second electrode of the first light-emitting device and a thickness of the second electrode of the second light-emitting device are decreased in order.

6. The display panel according to claim 5, wherein in the direction perpendicular to the array base plate (11), the functional layer (14) has different thicknesses at different parts corresponding to the respective light-emitting devices (13) of different colors,
   in the direction perpendicular to the array base plate (11), a thickness of the part of the functional layer (14) on the third light-emitting device, a thickness of the part of the functional layer (14) on the second light-emitting device, and a thickness of the part of the functional layer (14) on the first light-emitting device are increased in order.

7. The display panel according to any one of claims 5 to 6, wherein each of the light-emitting devices (13) comprises at least two light-emitting layers that are stacked along the direction perpendicular to the array base plate (11);

    in the direction away from the array base plate (11), the light-emitting device layer (132) comprises a hole injection layer (HIL), a first hole transport layer (HTL1), a first electron blocking layer (EBL1), a first light-emitting layer (EML1), a first hole blocking layer (HBL1), a first electron transport layer, an N-type charge generation layer, a P-type charge generation layer, a second hole transport layer (ETL1), a second electron blocking layer (EBL2), a second light-emitting layer (EML2), a second hole blocking layer (HBL2), a second electron transport layer (ETL2), and an electron injection layer (EIL) that are stacked in order;
    in the direction perpendicular to the array base plate (11), a sum of thicknesses of the first electron blocking layer (EBL1) and the second electron blocking layer (EBL2) in the first light-emitting device is a first thickness, a sum of thicknesses of the first electron blocking layer (EBL1) and the second electron blocking layer (EBL2) in the second light-emitting device is a second thickness, and a sum of thicknesses of the first electron blocking layer (EBL1) and the second electron blocking layer (EBL2) in the third light-emitting device is a third thickness, wherein the first thickness, the second thickness and the third thickness are decreased in order.

8. The display panel according to claim 6, in the direction perpendicular to the array base plate (11), a distance between the first light-emitting layer (EML1) and the first electrode (131) within the light-emitting device (13) is not less than a distance D, which is calculated as the following formula:

$$D=0.33*（\lambda/n）-54;$$

wherein $\lambda$ is a resonant wavelength of a microcavity (20) corresponding to the light-emitting device, and n is a refractive index of a medium between the first light-emitting layer (EML1) and the first electrode (131).

9. The display panel according to any one of claims 5 to 8, wherein the display panel further comprises a pixel definition layer (17) disposed on a side of the array base plate (11), and the isolation structure (12) is disposed on a side of the pixel definition layer (17) away from the array base plate (11);

the pixel definition layer (17) comprises a plurality of pixel openings, wherein an orthographic projection of the pixel opening on the array base plate (11) covers an orthographic projection of the light-emitting device (13) on the array base plate, and an orthographic projection of the isolation opening (121) on the array base plate covers the orthographic projection of the pixel opening on the array base plate; and
the second electrode (133) extends from the pixel opening to an edge of the isolation opening (121) and is electrically connected with the isolation structure (12).

10. The display panel according to claim 9, wherein the isolation structure (12) comprises an isolation part (123) and a barrier part (124) that are stacked, the barrier part (124) is disposed on a side of the isolation part (123) away from the array base plate (11), and an orthographic projection of the isolation part (123) on the array base plate (11) is located within an orthographic projection of the barrier part (124) on the array base plate (11);

the barrier part (124) protrudes from the isolation part (123) in a direction facing the isolation opening (121); and
the isolation structure (12) further comprises an isolation base (122), the isolation part (123) is disposed on a side of the isolation base (122) away from the array base plate (11), and an orthographic projection of the isolation part (123) on the array base plate (11) is located within an orthographic projection of the isolation base (122) on the array base plate (11);
the second electrode (133) extends from the pixel opening to the edge of the isolation opening (121) and overlaps with the isolation base (122).

11. The display panel according to claim 9 or 10, wherein the encapsulation layer (15) comprises a first encapsulation layer (151); and

the first encapsulation layer (151) comprises a plurality of encapsulation units, and each of the encapsulation units is configured to encapsulate one of the light-emitting devices (13) in a corresponding one of the isolation openings (121), and every two adjacent ones of the encapsulation units are separated by the isolation structure (12);
wherein the encapsulation layer (15) further comprises a second encapsulation layer (152) disposed on a side of the first encapsulation layer (151) away from the array base plate (11) and covering at least the first encapsulation layer (151); and
wherein the encapsulation layer (15) further comprises a third encapsulation layer (153) disposed on a side of the second encapsulation layer (152) away from the array base plate (11).

12. The display panel according to claim any of claims 3 to 7, wherein the first light-emitting device is a red light-emitting device, the second light-emitting device is a green light-emitting device, and the third light-emitting device is a blue light-emitting device.

13. The display panel according to claim 12, wherein in the direction perpendicular to the array base plate (11), a thickness of the second electrode of the blue light-emitting device, a thickness of the second electrode of the red light-emitting device and a thickness of the second electrode of the green light-emitting device are decreased in order; and
in the direction perpendicular to the array base plate (11), a thickness of part of the functional layer (14) on the blue light-emitting device, a thickness of the part of the functional layer (14) on the green light-emitting device and a thickness of the part of the functional layer (14) on the red light emitting-device are increased in order.

**14.** The display panel according to claim 12, wherein in the direction perpendicular to the array base plate (11), a thickness of the second electron blocking layer (EBL2) in the red light-emitting device, a thickness of the second electron blocking layer (EBL2) in the green light-emitting device and a thickness of the second electron blocking layer (EBL2) in the blue light-emitting device are decreased in order.

**15.** A display device, comprising the display panel according to any one of claims 1 to 14.

1

Fig. 1

Fig. 2

**Fig. 3**

**Fig. 4**

Fig. 5

Fig. 6

1

| 151 ⎤ | | 131 ⎤ | | 122 ⎤ |
| 152 ⎬15 | | 132 ⎬13 | | 123 ⎬12 |
| 153 ⎦ | | 133 ⎦ | | 124 ⎦ |

Fig. 7

| Condition | Difference in power consumption | 30° | 45° | 60° | 75° | 80° |
|---|---|---|---|---|---|---|
| | | JNCD | JNCD | JNCD | JNCD | JNCD |
| Related solution | - | 1.4 | 2.2 | 2 | 2.8 | 3.5 |
| Present solution | -31.50% | 0.8 | 1.3 | 1.8 | 2 | 2.2 |

Fig. 8

13

| | |
|---|---|
| EIL | |
| ETL2 | |
| HBL2 | |
| EML2 | |
| EBL2 | |
| HTL2 | |
| P-CGL | 132 |
| N-CGL | |
| ETL1 | |
| HBL1 | |
| EML1 | |
| EBL1 | |
| HTL1 | |
| HIL | |

133

131

**Fig. 9**

Blue sub-pixel device

| | |
|---|---|
| EIL | |
| ETL2 | |
| HBL2 | |
| B-EML2 | |
| EBL2(BPL2) | |
| HTL2 | |
| P-CGL | 132 |
| N-CGL | |
| ETL1 | |
| HBL1 | |
| B-EML1 | |
| EBL1(BPL1) | |
| HTL1 | |
| HIL | |

d32

d31

133

131

**Fig. 10**

HTL1 is fixed and HTL2 is being adjusted

HTL2 is fixed and HTL1 is being adjusted

Fig. 11

Red sub-pixel device

Fig. 12

**RPL1 is fixed and RPL2 is being adjusted**

**RPL2 is fixed and RPL1 is being adjusted**

**Fig. 13**

Blue sub-pixel device

**Fig. 14**

**GPL1 is fixed and GPL2 is being adjusted**

**GPL2 is fixed and GPL1 is being adjusted**

**Fig. 15**

| Present solution | BI maximum value | | |
|---|---|---|---|
| | | CIEy | BI% |
| | Stacked layer | 0.0500 | 203.1% |
| | EML 1 | 0.0531 | 103.1% |
| | EML2 | 0.0468 | 100% |

| Related solution | BI maximum value | | |
|---|---|---|---|
| | | CIEy | BI% |
| | Stacked layer | 0.0515 | 182.8% |
| | EML 1 | 0.0530 | 83.2% |
| | EML2 | 0.0474 | 100% |

**Fig. 16**

1

14    15

13

11

**Fig. 17**

1

131
132  13
133

14    15

132

131

11

131

**Fig. 18**

## EUROPEAN SEARCH REPORT

**Application Number**

EP 25 15 3134

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/364715 A1 (YOON SEOK-GYU [KR] ET AL) 17 December 2015 (2015-12-17) | 1-4,15 | INV. H10K59/122 |
| Y | * paragraphs [0001], [0046], [0049], [0063], [0077], [0082], [0084], [0088]; figures 1,2,7,11 * | 5-14 | H10K59/80 H10K50/15 H10K50/18 H10K50/852 |
| Y | CN 116 600 606 B (KUNSHAN GOVISIONOX OPTOELECTRONICS CO LTD) 19 December 2023 (2023-12-19) * paragraphs [0049], [0063], [0070]; figure 1 * | 5-14 | H10K102/00 H10K50/19 H10K50/85 |
| Y | US 2021/242419 A1 (NAKAMURA MASATO [JP] ET AL) 5 August 2021 (2021-08-05) * paragraphs [0075] - [0086], [0274] - [0275]; figure 3 * | 7,8,14 | |

**TECHNICAL FIELDS SEARCHED (IPC)**

H10K

The present search report has been drawn up for all claims

| Place of search | Date of completion of the search | Examiner |
|---|---|---|
| The Hague | 6 May 2025 | Baum, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

## ANNEX TO THE EUROPEAN SEARCH REPORT
## ON EUROPEAN PATENT APPLICATION NO.

EP 25 15 3134

06-05-2025

| Patent document cited in search report | Publication date | Patent family member(s) | | Publication date |
|---|---|---|---|---|
| US 2015364715 A1 | 17-12-2015 | KR | 20150144890 A | 29-12-2015 |
| | | US | 2015364715 A1 | 17-12-2015 |
| CN 116600606 B | 19-12-2023 | CN | 116600606 A | 15-08-2023 |
| | | CN | 119317329 A | 14-01-2025 |
| US 2021242419 A1 | 05-08-2021 | CN | 112243599 A | 19-01-2021 |
| | | JP | 2021182459 A | 25-11-2021 |
| | | KR | 20210015958 A | 10-02-2021 |
| | | US | 2021242419 A1 | 05-08-2021 |
| | | WO | 2019235475 A1 | 12-12-2019 |

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023134518 W
- CN 202310759370
- CN 202310740412
- CN 202310707209
- CN 202311346196